# EUROPEAN PATENT APPLICATION

(11) **EP 1 237 279 A1**
(43) Date of publication of application: **04.09.2002**
(21) Application number: 01830113.5
(22) Date of filing: 21.02.2001
(51) Int. Cl.: H03K 19/003, H03K 19/094

(54) **Output buffer with automatic control of the switching speed as a function of the supply voltage and temperature**

(71) Applicant: STMicroelectronics S.r.l., 20041 Agrate Brianza (Milano) (IT)
(72) Inventor: Bedarida, Lorenzo, 20059 Vimercate (Milano) (IT); Confalonieri, Emanuele, 20132 Milano (IT); Corradi, Andrea, 26100 Cremona (IT); Fiorina, Sara, 24027 Nembro (Bergamo) (IT)
(74) Representative: Siniscalco, Fabio

(57) **Abstract**

Output buffer in which the switching speed of the transistors (4,5) of the output stage (1) is kept constant, independently of the variations of the supply voltage (Vcc) and of the temperature, within the acceptable operating range for the device, by controlling, as a function of the supply voltage and the operating temperature detected by a correction circuit (14), the conductivity of additional transistors (13,15) in series with the transistors (7,8) of the predriving stage (2) which drive the transistors of the output stage in conduction, the transistors being driven by an analog signal (CNTRN, CNTRP) which is generated by the correction circuit (14) and is variable with the supply voltage and the operating temperature.

## Description

The present invention relates to an output buffer with automatic control of the switching speed which is made independent, at least within the limits of the operating range, of variations of the supply voltage and operating temperature.

It should be mentioned here that a buffer is an electronic logic device, inverting or non-inverting, for separating an input from an output and preventing any possible reaction from the circuit connected to the output to the circuit connected to the input.

In general, a buffer also has an amplification function of the fan-out type, in other words one capable of driving a high load, or a plurality of loads, without causing a significant load on the input circuit.

Preferably, it also has a function of isolating the output circuit, and therefore it is generally, but not necessarily, a device with three output states.

According to the input signal and an output enabling control signal, the buffer switches from one state to another: the output is switched or connected to one or other of the two poles, generally earth and the positive pole Vcc of a supply voltage, in a mutually exclusive way, or can be disconnected from both, by two output transistors, which may or may not be made conducting by a driver circuit.

To enable the device to be driven at a high operating frequency, of the order of 50 MHz or above, the output transistors must switch very rapidly, but this requirement runs counter to that of limiting the noise induced by the switching on the earth and on the supply voltage Vcc, which could cause problems in the interpretation of the output data.

The conflict becomes even more significant when uniformity of performance is required regardless of the variation of the operating temperature and the value of the supply voltage Vcc.

This is because it is known that electronic devices are designed to operate within an operating range delimited by permitted minimum and maximum values of both supply voltage and operating temperature.

It is also known that, as the temperature increases within the operating range, electronic devices tend to slow down (in other words, the propagation and switching times increase), whereas, when the voltage Vcc increases, still within the operating range, they tend to operate more quickly.

### KNOWN ART

In known devices, the switching speed is essentially determined by the inverters which drive the output transistors, again with an upper limit imposed by the size and characteristics of the output transistors: according to the size of the inverters it is possible to reach a higher speed, with a consequent increase in the disturbances caused in the power supply, or conversely to obtain a control signal with a lower slew rate, in such a way as to slow down the switching and consequently decrease the noise associated therewith.

However, the disadvantage of this approach is the lack of flexibility, since the system is not able to change its behaviour according to the operating conditions.

Consequently, a buffer designed to give a predetermined switching speed, with an acceptable noise level, when operating at maximum voltage and at minimum temperature, in other words in the corner of the operating range corresponding to the maximum switching speed, has a much lower switching speed and a lower noise level than that which is acceptable when it is operating in conditions corresponding to the opposite corner of the operating range. Its performance is degraded.

Conversely, a buffer designed to give a predetermined switching speed with an acceptable noise level, when operating at minimum voltage and maximum operating temperature, will increase its switching speed when operating in different conditions, but this will entail a rise in the induced noise level beyond the acceptable limits.

This serious problem is resolved by the buffer to which the present invention relates, which automatically controls its switching speed, making it independent of the operating conditions (of temperature and supply voltage), so that its performance remains unchanged and optimal.

Briefly, this result is achieved with a buffer whose components are designed to achieve a predetermined maximum switching speed when the device operates in the worst operating conditions for speed (low Vcc and high temperature), comprising a compensation circuit which generates two complementary analog control signals, one of which is variable inversely/directly with the supply voltage while the other is variable directly/inversely with the temperature, which have the effect, as will be seen, of reducing the switching speed when this tends to increase because the device is operating in conditions of lower temperature and with a higher voltage Vcc.

These signals are applied to the predriving stage (relating to the output which drives the output transistors which form the driving stage of the device).

The predriving stage also comprises, in series with each of the two inverter transistors which make the output transistors conduct, an additional control transistor, each of these control transistors being driven by a different one of the two analog signals in such a way that it has a variable conductivity such that the switching speed remains essentially unchanged throughout the operating range.

In other words, when increases in Vcc and decreases in temperature would tend to increase the switching speed, the correction circuit reduces the conductivity of the additional transistors connected in series, thus tending to slow the device down.

Advantageously, in order to avoid critical points in design and production, and to ensure repeatability and constancy of performance in the devices produced, a fixed resistive path (consisting in practice of another transistor) is provided in parallel with the additional transistors whose conduction is modulated.

Advantageously, in order to obtain a compensation curve which is not too steep, and to avoid the use of resistances which could adversely affect or complicate the thermal behaviour, the compensation circuit is of the current type, using current mirrors which incorporate the additional control transistors.

The characteristics and advantages of the invention will appear in greater detail in the following description of a preferred embodiment and variants thereof, which makes reference to the attached drawings in which:
- Fig. 1 is the circuit diagram of a buffer known in the art,
- Fig. 2 is the basic diagram, partially in block form, of a buffer made according to the present invention,
- Fig. 3 is a preferred circuit diagram of a predriving stage for a buffer made according to the present invention,
- Fig. 4 is an example of the layout of a compensation circuit for the buffer made according to the present invention,
- Fig. 5 is a preferred layout of a compensation circuit for the buffer made according to the present invention.

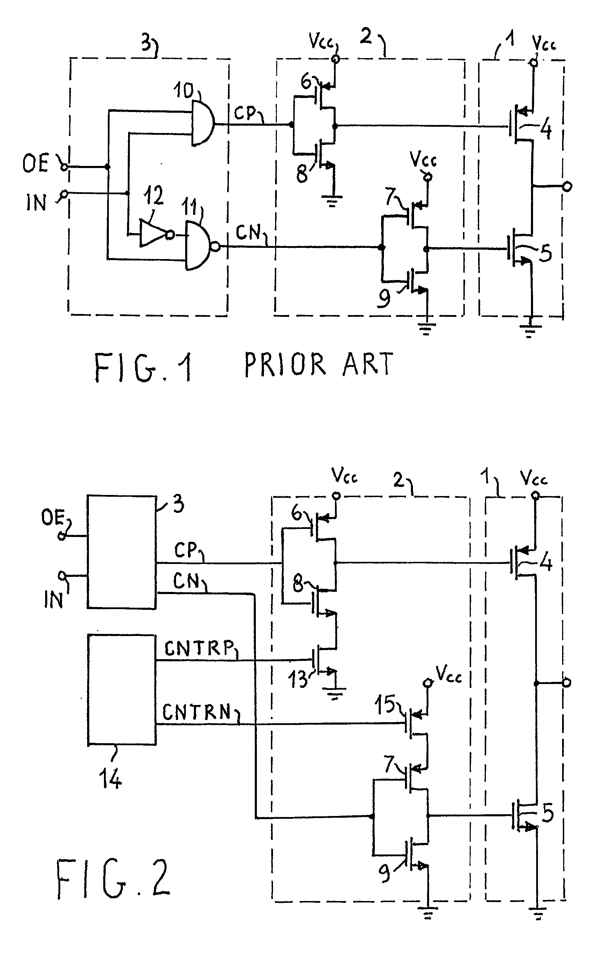

To enable the invention to be understood more clearly, Figure 1 shows the circuit diagram of an output buffer known in the art, made with CMOS technology. Buffers made with other technologies, such as TTL, have the same theoretical structure.

The buffer comprises an output stage 1, a predriving stage 2 and an input logic circuit 3.

The output, or driving, stage comprises a first transistor 4, of the p-channel type, with its source connected to a positive power supply terminal Vcc and its drain connected to an output terminal U, and at least a second transistor 5 (or a plurality of transistors in parallel), of the n-channel type, with its source connected to earth, or more generally to the reference pole of the power supply voltage Vcc, and its drain connected to the output terminal U.

When the transistors 4 and 5 are brought into conduction in a mutually exclusive way, the output terminal U is connected or switched to the voltage Vcc or to earth.

The predriving stage 2 comprises two p-channel transistors 6, 7, with their sources connected to the voltage Vcc and their drains connected, respectively, to the gates of the transistors 4, 5, and two n-channel transistors 8, 9, with their sources connected to earth and their drains connected, respectively, to the gates of the transistors 4, 5.

The input logic circuit 3 uses an input logic signal IN, and an output buffer enabling signal OE if present, to form two logic control signals CP, CN which are applied, respectively, to the gates of the transistors 6, 8 and to the gates of the transistors 7, 9.

The configuration of the input circuit depends on the function which the buffer is to provide and on the relation between the logical and electrical levels of the signals.

If the relation between the logical and electrical level is direct (1=Vcc, 0=0 V) and the buffer has to be of the non-inverting tri-state type (U=IN), as illustrated in Fig. 1, the signal CP is obtained as the output of an AND gate 10 which receives the signals OE, IN at its input, and the signal CN is obtained as the output of a NAND gate 11 which receives the signals OE and IN_ (obtained from IN through an inverter 12) at its input.

If the tri-state function is not required, the input circuit is superfluous (CP=CN=IN) for non-inverting buffers, or is reduced to a simple inverter (CP=CN=IN_) for an inverting buffer.

If the buffer is required to be of the inverting tri-state type (U=IN_), the NOT 12 at the input of the NAND 11 simply has to be removed and placed at the input of the AND gate 10.

As explained above, this type of buffer suffers from the drawback that its switching speed varies widely with the supply voltage and the operating temperature, with major implications for the induced switching noise.

Fig. 2 shows in a block diagram the structure of a buffer according to the present invention, which resolves this problem. Since the buffer of Fig. 2 differs from that of Fig. 1 only in certain modifications of the predriving stage or circuit 2 and in the addition of a compensation circuit, the elements which are functionally equivalent in the two figures are identified by the same reference numbers.

It should be noted that the output stage 1 and the input logic 3 are not modified in any way.

The predriving stage 2, which is in series with the n-channel transistor 8, which, when closed, causes the conduction of the output transistor 4 connected between the source of the transistor 8 and earth, contains a second n-channel transistor 13 with its source connected to earth.

The gate of the transistor 13 is driven by an analog control signal CNTRP sent from the output of a correction circuit 14.

The structure of the correction circuit will be considered subsequently; at this point it is sufficient to note that the signal CNTRP decreases with an increase in the supply voltage Vcc and a decrease in the operating temperature T.

Consequently, the conductivity of the transistor 13 (determined by Vgs, in other words the bias voltage present between the gate and the source) varies from a maximum (for a low Vcc and a high T) to a minimum (for a high Vcc and a low T), whose values are determined by the design of the transistor and by the amplitude of the signal CNTRP.

Clearly, therefore, the time constant RC of the discharge circuit of the gate of the transistor 4, consisting of the two transistors 8,13 in series, is controlled by the signal CNTRP and decreases when Vcc decreases and T increases, thus compensating for the effect of these factors on the speed of switching to conduction of the transistor 4, which remains practically unchanged.

Similarly, in the predriving stage 2, which is in series with the p-channel transistor 7, which, when closed, causes the conduction of the output transistor 5, a second p-channel transistor 15, with its source connected to the voltage Vcc, is connected between the source of the transistor 7 and the supply voltage.

The gate of the transistor 15 is driven by an analog control signal CNTRN sent from the output of the correction circuit 14.

The signal CNTRN increases with an increase in the supply voltage Vcc and a decrease in the operating temperature T.

Consequently, the conductivity of the transistor 15 (determined by Vgs) varies, as for the transistor 13, from a maximum (for a low Vcc and a high T) to a minimum (for a high Vcc and a low T), whose values are determined by the design of the transistor and by the amplitude of the signal CNTRN.

In this case again, therefore, compensation is provided for the effect of the variations of Vcc and T on the charge speed of the gate of the transistor 5, and consequently on its speed of switching to the conducting state, which remains practically unchanged.

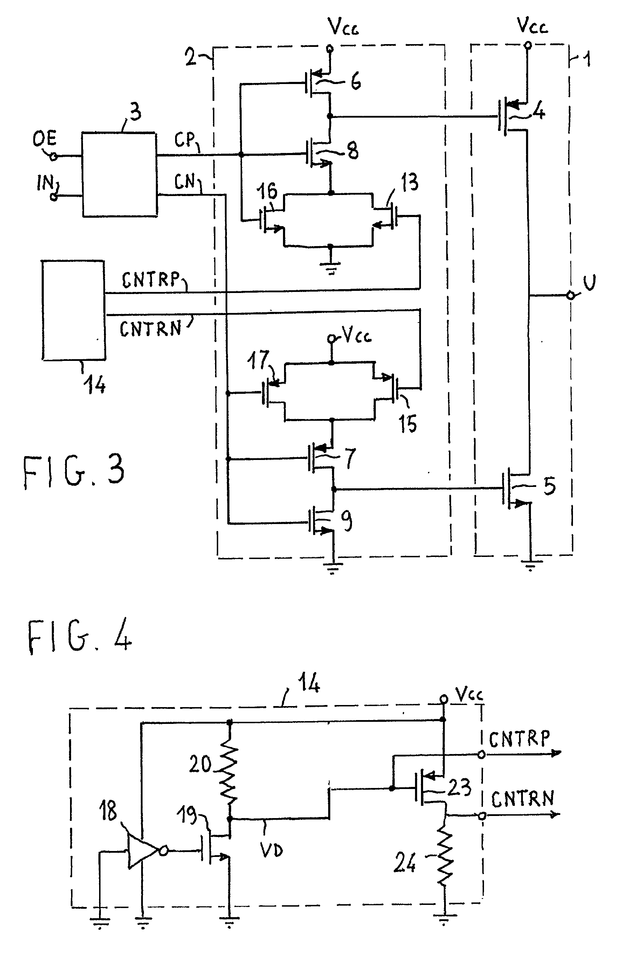

A more efficient approach, which eliminates critical design points and ensures better reproducibility and conformity of the device to the desired performance, makes use of the preferred embodiment of the predriving stage 2 shown diagrammatically in Figure 3, which increases the degrees of freedom of the design.

In Figure 3 it will be seen that an n-channel transistor 16, with its source connected to earth and its gate driven by the signal CP, is connected in parallel with the control transistor 13.

The transistors 8 and 16 form a fixed discharge path for the gate of the output transistor 4.

The transistor 16 can conveniently be designed, together with the transistor 8, to provide a predetermined switching speed in conditions of maximum voltage Vcc and minimum temperature.

In parallel with the transistor 16, the transistor 13 provides a path whose conductivity increases (with an increase in temperature and a decrease in the voltage Vcc) from a predetermined zero value (with the transistor 13 open) to a maximum value which provides the desired switching speed in the worst operating condition (low Vcc and high T).

The required maximum conductivity can be obtained by a suitable design of the transistor 13 and the zero conductivity condition can be produced by a control signal CNTRP in the range between 0 and the threshold voltage of the transistor, this signal being obtainable much more easily and with greater precision than a signal of predetermined amplitude other than 0.

Similarly, a p-channel transistor 17, with its source connected to the voltage Vcc and its gate driven by the signal CN, is provided in parallel with the control transistor 15.

The transistors 7 and 17 form a fixed charging path for the gate of the transistor 5 and are suitably designed to provide a predetermined switching speed in the conditions of maximum voltage Vcc and minimum temperature T.

In this case also, the control transistor 15 can be conveniently designed and driven to provide zero conductivity in the aforesaid conditions and sufficient conductivity to provide the desired switching speed in the worst operating condition. In this case, zero conductivity is produced by a signal CNTRN whose amplitude is in the range from Vcc to Vcc - Vts, where -Vts is the threshold voltage of the transistor.

It will be noted that the additional transistors 16 and 17 forming a fixed-conductivity path are driven by the signals CP and CN respectively. Although preferable, this is not necessary: since the switch function is already provided, in both the discharge and the charging path, by the transistors 8 and 7 respectively, the two transistors 16 and 17 can also be driven permanently in the conducting state by connecting their gates to the fixed voltages of Vcc and earth respectively.

With reference to Figure 4, we shall now consider a possible structure of the compensation circuit 14.

The circuit comprises an inverter 18 supplied by the voltage Vcc, with its input connected to earth, and an n-channel transistor 19 with its source connected to earth and its drain connected to Vcc through a resistor 20.

These three components are sufficient to provide a good approximation of the thermal and electrical behaviour of the device, and they can be designed in such a way that the voltage VD at the drain of the transistor 19 is practically zero at the maximum operating voltage Vcc and at the minimum temperature T, while VD increases to a maximum as Vcc decreases and as the temperature rises.

In other words, VD is equivalent to the signal CNTRP.

To obtain the signal CNTRN, which is the Vcc complement of CNTRP, it is sufficient to provide an inverter stage consisting of a p-channel transistor 23, having a source connected to Vcc, a drain connected to earth through a resistor 24, and a gate driven by CNTRP.

Clearly, when CNTRP=Vcc, CNTRN=0, and when VD (and therefore CNTRP) decreases, CNTRN increases.

Although simple, this correction circuit which operates on a voltage basis is difficult to produce with repeatable characteristics.

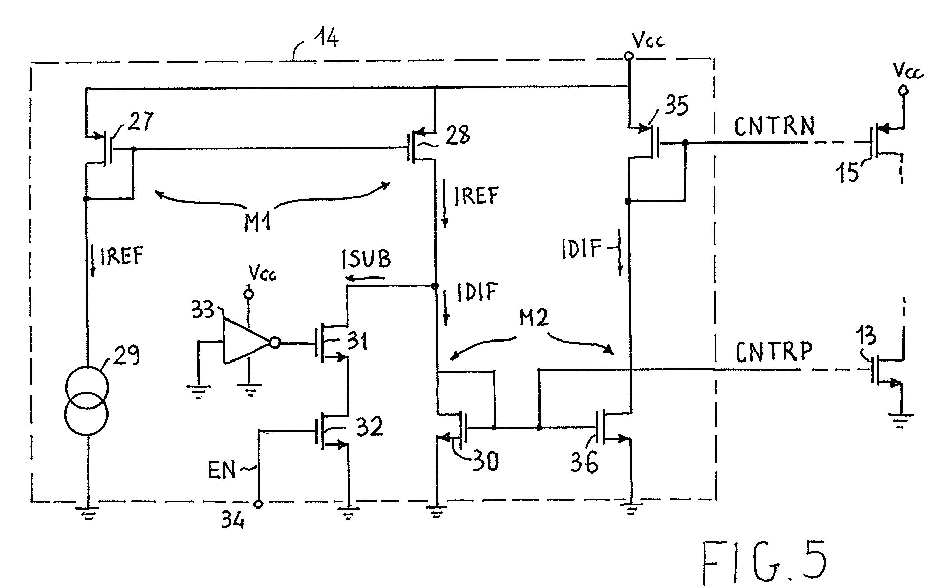

Figure 5 therefore shows a preferred embodiment which, although more complex in terms of circuitry, has no critical design points or difficulties in respect of manufacture.

It should be noted that, in a circuit of the large-scale integration type, generally comprising a large number of buffers (one for each output of the device), only one correction circuit is required to control the various buffers, and therefore the degree of complexity and consequently the overall size of the compensation circuit becomes insignificant in proportion to the overall size of the driving and predriving stages of the plurality of buffers.

Advantageously, the correction circuit of Fig. 5 operates on a current basis, with characteristics which are more easily controllable and predictable at the design stage and more easily reproducible without deviation at the production stage.

The control transistors are also driven by a current-based system (since the bias voltage Vgs of the gate is obtained from a current), with these transistors 'mirroring' the controlled current which flows in an output stage of the compensation circuit and which, together with the control transistors, forms mirror circuits.

With reference to Figure 5, the correction circuit 14, in a preferred embodiment, comprises a first current mirror circuit M1, of a conventional type, formed by two p-channel transistors 27,28, with their gates connected to each other, and by a generator 29 of constant reference current IREF, independent of Vcc and T, which generator connects the first branch of the mirror circuit to earth.

The constant current generator can be of the type described in US patent 5,103,159.

The diode connection of the transistor 27 and the common-gate connection of the two transistors 27,28 causes a current proportional to IREF, or equal to it if the two transistors are identical, to flow in the second branch of the mirror circuit, controlled by the transistor 28, when the branch is connected to earth.

For simplicity of description, it is assumed that the drain current of the transistor 28 is equal to IREF.

The second branch of the mirror circuit M1 is connected to earth along two parallel paths.

A first path consists of an n-channel transistor 30, connected in diode mode.

The second path consists of an n-channel transistor 31, preferably, but not necessarily, in series with another n-channel transistor 32.

The gate of the transistor 31 is biased by the output of an inverter 33, supplied with the voltage Vcc and with its input connected to earth.

The gate of the transistor 32 is connected to an input terminal 34 for the application of an enabling signal EN which causes the transistor 32 to conduct; in the absence of this signal, the transistor 32 is switched to the open state.

The enabling/disabling signal can be obtained simply by connecting the terminal to the voltage Vcc or to earth.

The components 31,32,33 reproduce the thermal and electrical behaviour of the whole device (buffer) by forming, between the drain of the transistor 28 and the source of the transistor 32 (when enabled), a current path to earth in which the current varies directly in proportion to the voltage Vcc and inversely with the temperature T.

Since the drain current of the transistor 28 is constant and equal (or proportional) to IREF, a current IDIF flows in the transistor 30; this current is calculated as IDIF=IREF-ISUB (Vcc,T) where ISUB (a function of Vcc and T) is the current flowing through the transistors 31,32.

Clearly, ISUB increases with a rise in Vcc and with a decrease in the temperature T.

The various components such as 31,32 are designed in such a way that, for a minimum Vcc and a maximum temperature T (the slowest corner of the operating range), the subtracted current ISUB is practically zero, and consequently IDIF=IREF, and for a maximum Vcc and a minimum temperature T (the fastest corner of the operating range) the subtracted current ISUB is equal to IREF, and consequently IDIF=0.

The gate of the transistor 30 is connected to the gate of the control transistor 13 of the predriving circuit, and the voltage present at the gate forms the signal CNTRP.

In fact, as can be seen, the transistors 30 and 13 form a current mirror circuit, and therefore a current equal to IDIF flows in the transistor 13.

Clearly, therefore, the transistor 13 has maximum conductivity when IDIF = IREF in the most unfavourable conditions where switching speed is concerned.

As the voltage Vcc increases and the temperature decreases, IDIF decreases to 0 and the conductivity of the transistor 13 decreases to 0, tending to slow down the switching of the output transistor 4 (Fig. 3).

For driving the transistor 15, use is made of a second current mirror circuit (M2) with one branch consisting of the transistor 30 and the other branch formed by two transistors 35,36 in series, connected between the voltage Vcc and earth, one (35) of the p-channel type with a diode connection of the gate, and the other (36) of the n-channel type connected to the transistor 30 in common-gate mode.

Clearly, a current equal to IDIF flows in this branch as well. The gate of the transistor 35 is connected to the gate of the predriving transistor 15, which, together with the transistors 35,36, forms a further current mirror circuit.

The voltage present at the gate of the transistor 35 forms the signal CNTRN.

In this case also, as the voltage Vcc increases and the temperature decreases, the current IDIF decreases to zero, as does the conductivity of the transistor 15, and this tends to slow down the switching of the output transistor 5 with an action compensating for the effect of voltage and temperature.

It should be noted that, whereas the signal CNTRP, considered as the voltage between the gates of the transistors 30,36,13 and earth, which is taken as the reference value, varies directly with IREF, the signal CNTRN, considered as the voltage between the gates of the transistors 35,15 and earth, which is again taken as the reference value, varies inversely with IDIF.

However, if the supply voltage Vcc is taken as the reference for the signal CNTRN, the signal CNTRN also varies directly with IDIF.

Conceptually, the control circuit 14 can be considered in a general way as a generator of a single monitoring and control signal, of either the voltage or the current type, which can be varied inversely with the increase of the voltage Vcc and with the decrease of T, and which biases the transistors 13 and 15 and modulates their conductivity from a maximum value to a zero value as the voltage Vcc increases and the temperature decreases.

A brief mention should be given of the enabling signal EN of the control circuit 14, which is preferably but not necessarily made available at a terminal 34 of the device.

The noise induced by the switching of the output transistors 13,15 is a function not only of the switching speed, but also of the load impedance connected to the output terminal U.

If the load impedance is high in certain applications, the switching noise is lower, and it may be convenient to make it possible for the device to be operated at the maximum possible speed for the various operating conditions.

Additionally, a high load impedance causes a lower power dissipation within the circuit, and therefore, in general, a lower internal operating temperature and a lower power requirement; consequently the device is likely to operate in the proximity of the fastest corner.

Thus the possibility of preventing the operation of the compensation circuit according to foreseeable conditions of use makes it possible to produce a versatile device which adapts itself to different requirements with optimal performance, in different cases in terms of switching speed and acceptable disturbances.

## Claims

1. Output buffer in which an output terminal (U) is connected to one or other of two terminals of a supply voltage, by a first (5) and second (4) output transistor respectively, these output transistors being driven in conduction by a first (7) and a second (8) predriving transistor respectively, these predriving transistors being made to conduct, in a mutually exclusive way, by an input stage (3), **characterized in that** it comprises,
- a compensation circuit (14) which generates a first (CNTRP) and a second (CNTRN) analog control signal, these signals being complementary to each other and variable, respectively, in an inverse/direct way with the supply voltage and in a direct/inverse way with the operating temperature of the buffer,
- a third transistor (15) driven by said second signal (CNTRN), and connected in series with said first predriving transistor (7) between one (Vcc) of the supply terminals and said first predriving transistor (7), and
- a fourth transistor (13) driven by said first signal (CNTRP) and connected in series with said second predriving transistor (8) between the other supply terminal and said second predriving transistor.

2. Output buffer according to Claim 1, comprising
- a fifth transistor (17) connected in parallel with said third transistor (15) and driven, in conduction, at least jointly with said first predriving transistor (7), and
- a sixth transistor (16) connected in parallel with said fourth transistor (13) and driven, in conduction, at least jointly with said second predriving transistor (8).

3. Output buffer according to Claim 1 or 2, in which said compensation circuit (14) comprises
- a generator (29) of constant current (IREF), which does not vary with the supply voltage (Vcc) and the operating temperature,
- a first current mirror circuit (M1) with a first branch (27,29) supplied by said constant current generator and a second branch (28) in which said constant current IREF is mirrored,
- active components (31,33) which subtract from said second branch a current (ISUB) which is variable directly with the supply voltage and inversely with the operating temperature,
- a second current mirror circuit (M2) with a first branch (30) supplied by the residual current (IDIF) of the second branch of the first current mirror circuit, and a second branch (33,34) in which said residual current is mirrored, and in which: said third transistor (15) forms a further current mirror circuit with the second branch (33,34) of said second current mirror circuit, and said fourth transistor (13) forms a further current mirror circuit with the first branch (30) of said second current mirror circuit (M2).

4. Buffer according to Claims 1, 2 and 3, in which said compensation circuit (14) is provided with an enabling terminal for activating said compensation circuit in response to an external command.
